## Europäisches Patentamt

## European Patent Office

## Office européen des brevets

(19)

(11) Veröffentlichungsnummer: **0 111 028**

**B1**

(12) **EUROPÄISCHE PATENTSCHRIFT**

(45) Veröffentlichungstag der Patentschrift:
12.08.87

(51) Int. Cl.⁴: **H 03 K 17/08**

(21) Anmeldenummer: **82111541.7**

(22) Anmeldetag: **13.12.82**

(54) **Leistungsschalter, insbesondere Leistungstransistorschalter.**

(43) Veröffentlichungstag der Anmeldung:
**20.06.84 Patentblatt 84/25**

(45) Bekanntmachung des Hinweises auf die Patenterteilung:
**12.08.87 Patentblatt 87/33**

(84) Benannte Vertragsstaaten:
**AT BE CH DE FR GB IT LI LU NL SE**

(56) Entgegenhaltungen:
DE-A-2 415 305
FR-A-2 189 943
FR-A-2 220 112
FR-A-2 325 193

(73) Patentinhaber: **FRAUNHOFER- GESELLSCHAFT ZUR FÖRDERUNG DER ANGEWANDTEN FORSCHUNG E.V., Leonrodstrasse 54, D-8000 München 19 (DE)**

(72) Erfinder: **Meier, Horst, Dr.- Ing., Am Pichelsee 31a, D-1000 Berlin 30 (DE)**
Erfinder: **Müller, Gottfried, Lehrter Strasse 62, D-1000 Berlin 21 (DE)**

(74) Vertreter: **Kraus, Walter, Dr., Patentanwälte Kraus, Weisert & Partner Thomas- Wimmer- Ring 15, D-8000 München 22 (DE)**

EP 0 111 028 B1

## Beschreibung

Die Erfindung betrifft einen Leistungsschalter, insbesondere einen Leistungstransistorschalter, mit einer den durch das Leistungsschalterelement fließenden Strom überwachenden und ein Überschreiten eines vorbestimmten Grenzstromwerts durch Steuerung des Leistungsschalterelements verhindernden Strombegrenzungsschaltung, und mit einer den Spannungsabfall am Leistungsschalterelement, insbesondere an einem Leistungstransistor, überwachenden Spannungsüberwachungsschaltung, die in einer Mitkopplungsschaltung mit der Strombegrenzungsschaltung verbunden ist. Außerdem betrifft die Erfindung die Anwendung dieses Leistungsschalters für die mehrachsige computerisierte numerische Steuerung von Werkzeugmaschinen oder Industrierobotern.

Bei der bisherigen computerisierten numerischen Steuerung von Werkzeugmaschinen, Industrierobotern o.dgl., war es erforderlich, die Leistungsschalter, mit denen die Stellglieder, zum Beispiel Magnetventile, Magnetbremsen, Hydraulikventile, Pumpen, große Steuerschütze etc., betätigt werden, gesondert von der eigentlichen Steuereinrichtung vorzusehen, weil diese Leistungsschalter im Kurzschluß- und Überlastungsfall eine erhebliche Wärme entwickeln, die es unmöglich macht, sie zusammen mit den Steuerschaltungen in einem Baustein, zum Beispiel auf einer Schaltungsplatte, vorzusehen, oder weil einige solcher Leistungsschalter, z. B. Relais, nur eine begrenzte Anzahl von Schaltspielen haben, wodurch es unpraktisch ist, sie in der vorgenannten Weise mit den Steuerschaltungen zusammenzubauen.

Diese Auftrennung hat zur Folge, daß bisher sogenannte Maschinenverteiler notwendig sind, mittels deren die Steuersignale zu den verschiedenen Leistungsschaltern, die an den verschiedensten Stellen der jeweiligen Maschine angeordnet sind, verteilt werden mussen. Das bedeutet einen ganz erheblichen Aufwand an Verdrahtung, die jeweils an der speziellen Maschine ausgeführt werden muß und, abgesehen von dem Arbeits- und Zeitaufwand, die Möglichkeit beinhaltet, daß viele Fehler beim Herstellen der Anschlüsse entstehen, die dann in mühseligem zusätzlichem Zeit- und Arbeitsaufwand korrigiert werden müssen.

Es ist daher wünschenswert, einen Leistungsschalter zur Verfügung zu haben, der mittels einer sehr geringen Steuerleistung betätigt werden kann und in der Lage ist, verhältnismäßig große Leistungen zu schalten, wie sie zur Betätigung von Stellgliedern erforderlich sind, ohne daß er im Kurzschluß- und Überlastungsfall eine nennenswerte Verlustleistung erzeugt.

Aus der FR-A-2 325 193 ist ein Leistungsverstärker bekannt, in welchem ein die Leistungsverstärkung eines Eingangssignals bewirkender Leistungsverstärkungstransistor durch eine Überwachungsschaltungsanordnung vor Überlastung geschützt wird. Diese Überwachungsschaltung ist so ausgebildet, daß sie dann, wenn sich eine übermäßige Spannung am Leistungsverstärkungstransistor und/oder eine übermäßige Ausgangsstromstärke des Leistungsverstärkungstransistors ergibt, das dem Leistungsverstärkungstransistor zugeführte und von diesem zu verstärkende Eingangssignal mittels eines Transistors teilweise nach Masse hin kurz schließt, so daß dadurch die Ausgangsleistung des Leistungsverstärkungstransistors begrenzt wird. Dieses Funktionsprinzip ist, da es auf einer Rückwirkung auf ein zu verstärkendes Eingangssignal beruht, nicht auf Leistungsschalter anwendbar, bei denen kein zu verstärkendes Eingangssignal vorhanden ist.

Aber aus der DE-A-2 415 305 ist ein Leistungsschalter der eingangs genannten Art bekannt, der es ermöglicht, einen als Leistungsschalterelement vorgesehenen Leistungstransistor im Kurzschluß- und Überlastungsfall abzuschalten und dabei zu erreichen, daß dessen maximale Verlustleistung im Störungsfall nur geringfügig höher ist als die Verlustleistung bei normalen Betriebsverhältnissen.

Jedoch hat der Leistungsschalter nach der DE-A-2 415 305 unter anderem den Nachteil, daß ein Schalten von kapazitiven Lasten zum sofortigen Wiederabschalten des Leistungstransistors führt, weil die Spannungsüberwachungsschaltung unverzögert auf den Spannungsabfall am Leistungstransistor anspricht; insbesondere ergibt sich der Nachteil, daß ein Wiedereinschalten des Leistungstransistors nach Beseitigung eines Kurzschlusses, der zum Abschalten des Leistungstransistors geführt hat, nur durch kurzzeitiges Wegnehmen der Betriebsspannung möglich ist.

Aufgabe der Erfindung ist es, einen Leistungsschalter der eingangs genannten Art so auszubilden, daß es ermöglicht wird, im Falle einer Abschaltung aufgrund von Kurzschluß oder Überlastung den Leistungsschalter, der dann in den selbstsperrenden Zustand übergeht, wieder einzuschalten, ohne daß die Betriebsspannung kurzzeitig weggenommen werden muß.

Diese Aufgabe wird erfindungsgemäß dadurch gelöst, daß die Spannungsüberwachungsschaltung an das das Leistungsschalterelement schaltende Steuersignal angekoppelt, ohne dieses Steuersignal unwirksam und eine durch das Steuersignal entsperrbare Transistorschaltung ist.

Auf diese Weise ist es bei einfachem Aufbau möglich, den Leistungsschalter nach einer Abschaltung aufgrund von Kurzschluß oder Überlastung wieder zu entsperren, indem das Steuersignal kurzzeitig weggenommen wird, nachdem der Kurzschluß oder die Überlastung

...seitigt ist.

Wegen der äußerst schnellen Abschaltung, die mittels des erfindungsgemäßen Leistungsschalters im Kurzschluß- und im Überlastungsfall erzielt wird, ist vorzugsweise die Spannungsüberwachungsanordnung mit einem Schaltelement versehen, welches das Wirksamwerden derselben im Einschaltfall verzögert, und zwar derart, daß die Spannungsüberwachungsschaltung erst nach einigen Mikrosekunden bis Millisekunden aktiv wird. Auf diese Weise wird verhindert, daß kurzzeitige Überlastungen, wie sie von verschiedenen Verbrauchern im Moment des Einschaltens vorkommen, ungewollt zum Abschalten und Selbstsperren des Leistungsschalters führen, denn im Kurzschluß- und Überlastungsfall kommt es nahezu augenblicklich, nämlich im Bereich von Mikrosekunden, zum Ausschalten des Leistungsschalterelements, insbesondere eines Leistungstransistors, wobei das Leistungsschalterelement im Kurzschluß- und Überlastungsfall praktisch keine Verlustleistung erzeugt, was in der Praxis heißt, daß die mögliche Verlustleistung vernachlässigbar klein ist, nämlich im Milliwatt-Bereich liegt. Wie durch Untersuchungen festgestellt werden konnte, ist die mit dem Leistungsschalter erzielbare Abschaltzeit so klein, daß sie im wesentlichen gleich der datenmäßig angegebenen überhaupt möglichen Abschaltzeit eines Leistungstransistors ist.

Eine wesentliche Anwendung dieses Leistungsschalters besteht gemäß der Erfindung darin, daß er als Leistungsausgangsstufe zusammen mit der sein Steuersignal erzeugenden Steuerschaltung in einer gemeinsamen Steuerbaueinheit, insbesondere auf einer Steuerkarte, für computerisierte numerische Steuerung vorgesehen ist, und zwar ist er vorzugsweise in Vielfachanordnung auf diesem Steuerbaustein, insbesondere der Steuerkarte, zum Schalten von digitalen Ausgängen vorgesehen, in welchem Steuerbaustein bzw. auf welcher Steuerkarte zum Erzeugen der Steuersignale wenigstens ein Prozessor mit Speicher und analoge und digitale Eingänge sowie gegebenenfalls digitale und/oder analoge Ist- und/oder Sollwertschaltungen und gegebenenfalls eine oder mehrere Schnittstellen zum Anschluß an Datenverarbeitungseinrichtungen und Bedienungseinrichtungen vorgesehen sind.

Der Leistungsschalter kann so ausgelegt werden, daß er einen Strom von bis zu 2 A bei einer Spannung bis zu 40 V kurzschlußfest und überlastsicher schalten kann, wobei er eingangsseitig nur eine geringe Steuerleistung, zum Beispiel ein TTL-Signal von 2,5 V und 16 mA benötigt (TTL = Transistor-Transistor-Logik).

Die vorstehenden sowie weitere Vorteile und Merkmale der Erfindung seien nachfolgend unter Bezugnahme auf die Figuren 1 bis 3 der Zeichnung anhand einiger, besonders bevorzugter Ausführungsformen der Erfindung näher erläutert; es zeigen:

Figur 1 eine Ausführungsform eines Leistungsschalters nach der Erfindung, und zwar im wesentlichen als Blockschaltbild dargestellt;

Figur 2 eine näher ausgeführte Schaltung einer besonders bevorzugten Ausführungsform eines Leistungsschalters, welcher den in Figur 1 dargestellten grundsätzlichen Aufbau hat und als Leistungstransistorschalter ausgefürt ist; und

Figur 3 eine Steuerkarte für mehrachsige computerisierte numerische Steuerung von Werkzeugmaschinen oder Industrierobotern, auf welcher der erfindungsgemäße Leistungsschalter in Vielfachanordnung vorgesehen ist und die erst durch den Leistungsschalter nach der Erfindung ermöglicht wird.

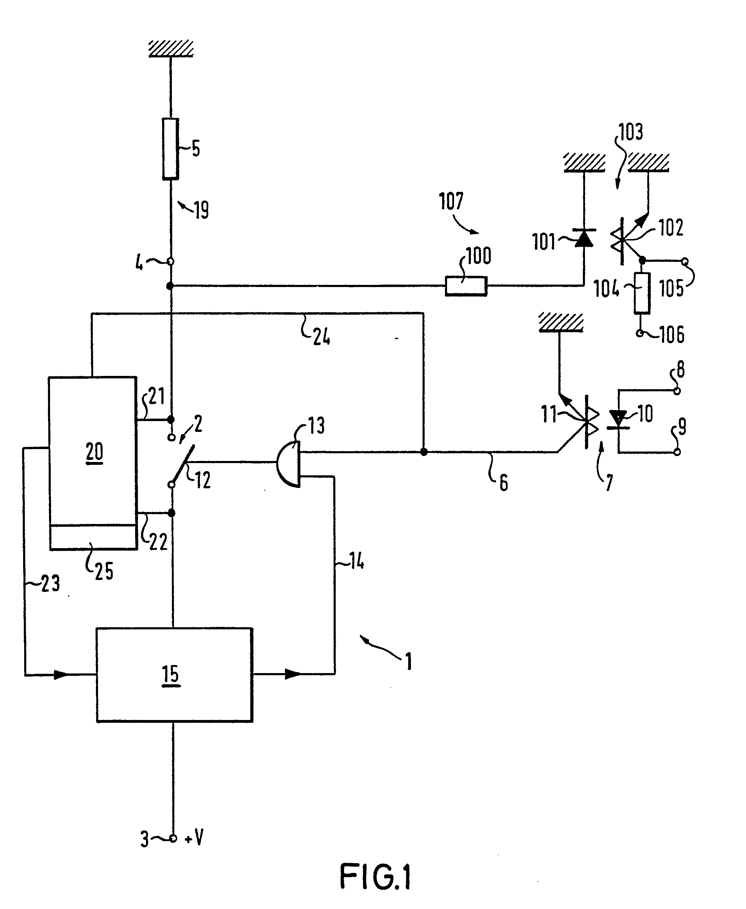

Es sei zunächst anhand des Blockschaltbilds der Figur 1 eine bevorzugte Grundausbildung des Leistungsschalter dargestellt. Dieser Leistungsschalter, der insgesamt mit 1 bezeichnet ist, umfaßt das eigentliche Leistungsschalterelement 2. Da der Leistungsschalter bevorzugt ein Leistungstransistorschalter ist, ist dieses Leistungsschalterelement 2 vorzugsweise ein Leistungstransistor. Der Leistungsschalter liegt im Stromkreis zwischen dem Anschluß 3, an dem beispielsweise eine positive Versorgungsspannung +V angeschlossen ist, die natürlich auch eine negative Versorgungsspannung sein kann, und einem Anschluß 4, an den die Last 5 angeschlossen wird, die mittels des Leistungsschalterelements 2 ein- oder ausgeschaltet werden soll.

Die Last 5 ist im Falle von Maschinen- oder Prozeßsteuerungen oder von sonstigen Industrierobotern, die über den Leistungsschalter 1 betätigt werden sollen, ein Stellglied, zum Beispiel ein Magnetventil, eine Magnetbremse, ein Hydraulikventil, eine Pumpe, ein großer Steuerschütz etc.

Das Steuersignal, welches das Öffnen oder Schließen des Leistungsschalterelements 2 bewirkt, wird über eine Steuersignalleitung 6 zugefürt, die im vorliegenden Beispielsfall zum Zwecke der galvanischen Entkopplung mit der entsprechenden Steuereinrichtung durch einen Optokoppler 7 verbunden ist, so daß also das eigentliche Steuersignal über die Anschlüsse 8 und 9 einer lichtemittierenden Diode 10 zugeführt und von einem Phototransistor 11 aufgenommen wird, der direkt an die Steuersignalleitung 6 angekoppelt ist.

Als Verbindungsglied zwischen der Steuersignalleitung 6 und dem Steueranschluß 12 des Leistungsschälterelements 2 ist ein UND-Tor 13 eingezeichnet, weil eine Betätigung des Leistungsschalterelements 2 nur möglich sein soll, wenn es durch die nachfolgend beschriebene Schaltung geschützt ist, mittels deren ein internes Steuersignal erzeugt wird. Dieses interne Steuersignal wird über die Steuersignalleitung 14 von einer Strombegrenzungsschaltung 15 her zugeführt, so daß also der eine Eingang des UND-Tors 13 mit der Steuersignalleitung 6 und der andere Eingang dieses UND-Tors mit der Steuersignalleitung 14 verbunden ist, während der Ausgang des UND-Tors 13 an den Steueranschluß 12 angeschlossen ist.

Die Strombegrenzungsschaltung 15 liegt nach der Darstellung der Figur 1 in Reihe mit dem Leistungsschalterelement 2 und der Last 5, weil sie im allgemeinen einen Stromfühlwiderstand aufweist, welcher direkt in den Stromkreis der Last geschaltet ist; es kann natürlich auch eine induktive oder sonstige Stromfühlschaltung vorgesehen sein. Die Strombegrenzungsschaltung 15 überwacht infolgedessen den durch den Leistungsschalter 1, d.h. genauer gesagt den durch das Leistungsschalterelement 2, hindurchfließenden Strom und verhindert ein Überschreiten eines vorbestimmten Grenzstromwerts im Lastkreis 19 und damit im Leistungsschalterelement 2. Das geschieht dadurch, daß die Strombegrenzungsschaltung 15 das Leistungsschalterelement 2 je nach dem durch dasselbe im Lastkreis 19 hindurchfließenden Strom mehr oder weniger sperrt. Die Strombegrenzungsschaltung 15 ist also im allgemeinen eine Regelschaltung, die den Strom, der durch das Leistungsschalterelement 2 fließt, immer konstant zu halten versucht.

Außer der Strombegrenzungsschaltung 15 weist der Leistungsschalter 1 noch eine Spannungsüberwachungsschaltung 20 auf, welche den am Leistungsschalterelement 2 entstehenden Spannungsabfall mißt und infolgedessen über Anschlußleitungen 21 und 22 mit den beiden Schalteranschlüssen des Leistungsschalterelements 2 verbunden ist. Der Ausgang der Spannungsüberwachungsschaltung 20, an dem ein Spannungsfehlersignal erhalten wird, das umso größer ist, je größer der Spannungsabfall am Leistungsschalterelement 2 ist, ist über die Leitung 23 mit der Strombegrenzungsschaltung 15 verbunden, und zwar derart, daß das Spannungsfehlersignal der Strombegrenzungsschaltung zusätzlich zu dem Stromfehlersignal, das diese Strombegrenzungsschaltung 15 aus der Strommessung erzeugt, als weiteres Steuersignal zugeführt wird. Dieses Steuersignal wirkt in der Strombegrenzungsschaltung 15 so, als ob die Strombegrenzungsschaltung einen zu hohen Strom "wahrnehmen" würde, so daß sie zum Zwecke des Verminderns des durch das Leistungsschalterelement 2 fließenden Stroms ein entsprechendes Gesamtfehlersignal über die Leitung 14 und das UND-Tor 13 auf den Steueranschluß 12 gibt, wodurch das Leistungsschalterelement 2 etwas mehr geöffnet wird. Dadurch wiederum kommt es zu einem noch größeren Spannungsabfall am Leistungsschalterelement 2, so daß infolgedessen die Spannungsüberwachungsschaltung 20 ein noch größers Spannungsfehlersignal auf der Leitung 23 erzeugt, welches wiederum über die Strombegrenzungsschaltung 15 im Sinne eines weiteren Öffnens des Leistungsschalterelements 2 wirkt, etc.

Die Spannungsüberwachungsschaltung 20 ist infolgedessen in einer Mitkopplungsschaltung mit der Strombegrenzungsschaltung 15 verbunden, und die Zeit, innerhalb deren eine solche Mitkopplung zum völligen Ausschalten des Leistungsschalterelements 2 führt, ist äußerst kurz, sie beträgt beispielsweise, wie durch Untersuchungen im Rahmen der vorliegenden Erfindung festgestellt wurde, nur Mikrosekunden.

Aufgrund des Vorgangs der Mitkopplung als solchem und aufgrund der außerordentlichen Schnelligkeit, mit der dadurch das Ausschalten des Leistungsschalterelements 2 bewirkt wird, sind in der Schaltungsanordnung nach Figur 1 zwei über die vorstehend beschriebene grundsätzliche Schaltung hinausgehende zusätzliche Schaltungsmaßnahmen vorgesehen:

(a) Da der Vorgang der Mitkopplung vorliegend zur Folge hat, daß sich der Leistungsschalter 1 auch weiterhin selbst sperrt, wenn er einmal durch einen Kurzschluß oder eine Überlastung aufgrund der Mitkopplung in den sperrenden Zustand übergegangen ist, ist die Spannungsüberwachungsschaltung 20 über eine Leitung 24 mit der Steuersignalleitung 6 verbunden, und das über die Leitung 24 zugeführte Steuersignal wird in der Spannungsüberwachungsschältung 20 dazu benutzt, diese zu entsperren, so daß also die Spannungsüberwachungsschaltung 20 beim Abschalten des Steuersignals unwirksam gemacht wird und infolgedessen die Selbstsperre des Leistungsschalterelements 2 nach einem durch Kurzschluß oder Überlastung bewirkten Ausschalten aufgehoben wird. Daher ist es zur Aufhebung der Selbstsperre des Leistungsschalterelements 2 lediglich notwendig, über einen geeigneten Schalter, der zum Beispiel im Kreis der lichtemittierenden Diode 10 liegen kann, oder in sonstiger geeigneter Weise, die Zuführung des Steuersignals kurz zu unterbrechen, nachdem der Kurzschluß- oder Überlastungszustand im Lastkreis 19 nicht mehr vorliegt.

(b) Da die Mitkopplung, wie erwähnt, in äußerst kurzer Zeit wirkt, ist die Spannungsüberwachungsschaltung 20 mit einem deren Wirksamwerden beim Einschalten verzögernden Schaltelement 25 versehen. Auf diese Weise wird erreicht, daß kurzzeitige Überlastungen im Lastkreis 19, die noch nicht zur Zerstörung oder ernsthaften Beschädigung oder Erwärmung des Leistungsschalterelements 2 führen, noch keine Abschaltung des Leistungsschalterelements 2 bewirken können. Das ist wichtig, damit nicht irgendwelche im Betrieb auftretende und an sich zulässige Stromstöße in unerwünschter Weise ein Abschalten des Leistungsschalterelements 2 zur Folge haben.

Damit die Steuerschaltung, zum Beispiel der darin vorgesehene Rechner, Prozessor o.dgl., feststellen kann, ob und an welcher Stelle ein Kurzschluß oder eine Überlastung aufgetreten ist, ist eine Rückführung 107 vorgesehen, die von dem Anschluß 4 ausgeht und über einen Widerstand 100 sowie einen Optokoppler 103, bestehend aus einer lichtemittierenden Diode 101 und einem Phototransistor 102 mit pull-up-Widerstand 104, am Anschluß 105 ein Signal liefert, welches anzeigt, ob das Leistungsschalterelement 2 bzw. 26 durchgeschaltet hat.

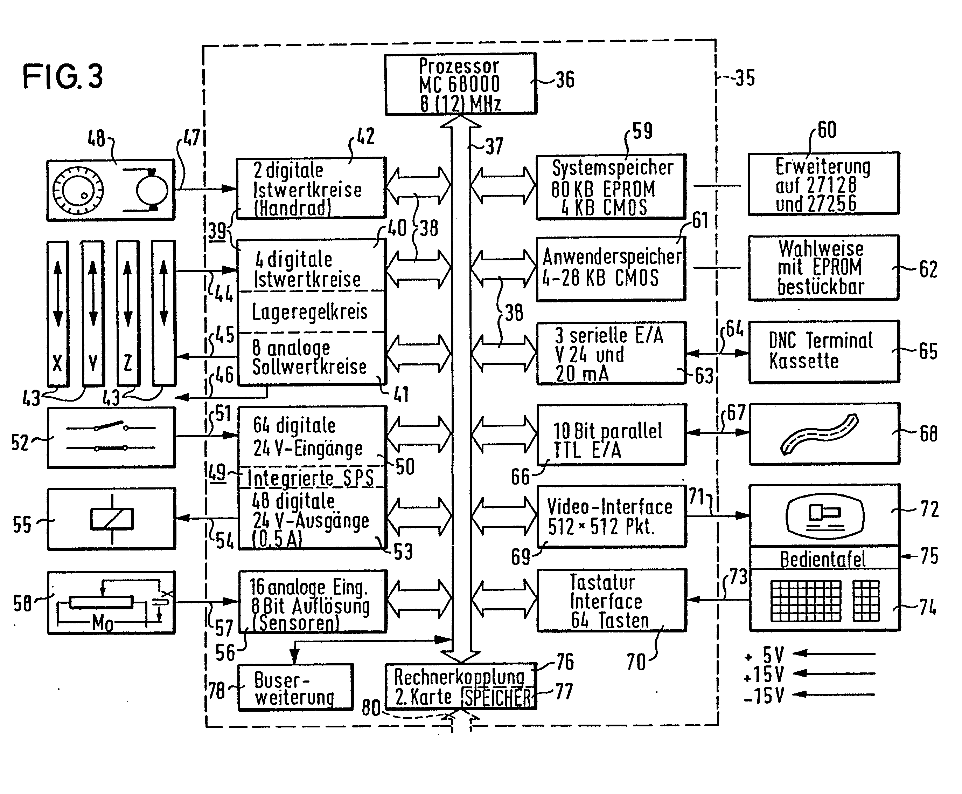

Des weiteren gestattet diese Rückführung auch die Verwendung dieses Leistungsschalters 1 bzw. 27 als Eingangsschaltung (siehe 50 in Figur 3), wenn am Anschluß 4 die Versorgungsspannung (zum Beispiel 24 Volt) angelegt wird, wobei dann natürlich die Last 5 entfällt. Dabei bleibt zwar das Leistungsschalterelement 2 bzw. 26 unbenutzt, aber die Steuereinheit, zum Beispiel die Einkarte 35 (Figur 3), läßt sich vielseitiger verwenden, da eine variable Aufteilung der Ein- und Ausgangsschaltungen in Ein- und Ausgänge per Programm möglich ist.

Selbstverständlich kann diese Rückführung auch anders als dargestellt ausgebildet sein, entscheidend ist, daß sie ein den Spannungszustand am Anschluß 4 repräsentierendes Signal liefert.

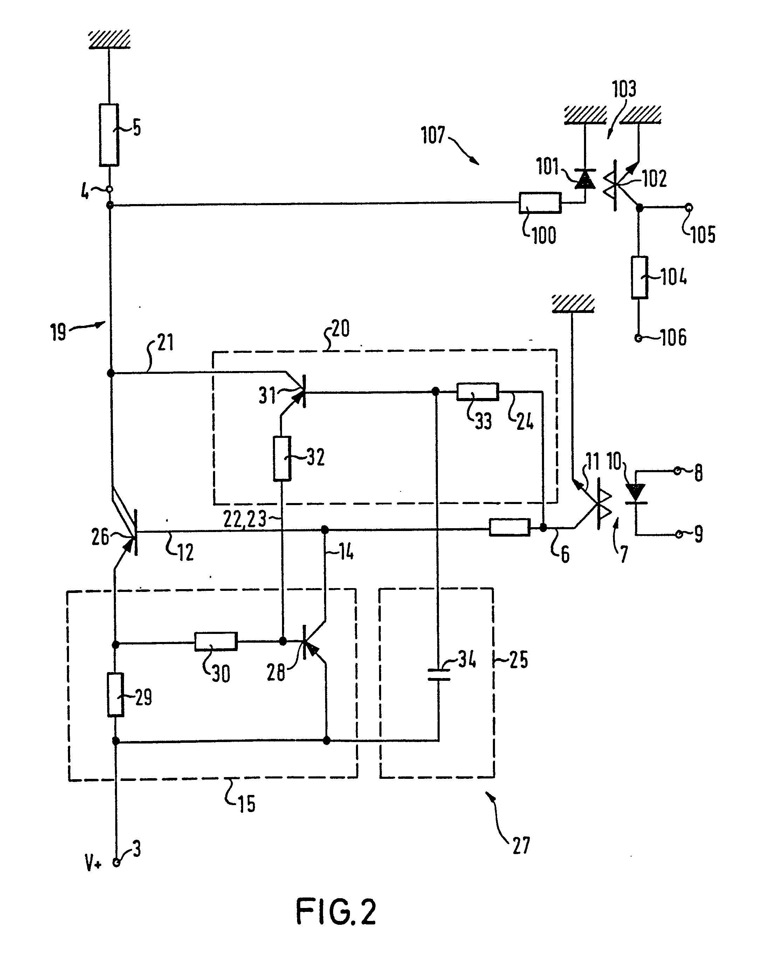

Es sei nun auf die Figur 2 Bezug genommen, in der das Leistungsschalterelement 2 der Figur 1 ein Leistungstransistor 26 ist. Es sei an dieser Stelle darauf hingewiesen, daß, abgesehen von einzelnen Schaltelementen, im allgemeinen die Bezugzeichen der Figur 1 auch in Figur 2 verwendet worden sind, so daß Schaltung der Figur 2 im Prinzip, abgesehen von den nachstehend beschriebenen Einzelheiten, aus der obigen Erläuterung der Schaltung nach Figur 1 verständlich ist.

Bei dem in Figur 2 dargestellten, insgesamt mit 27 bezeichneten Leistungsschalters sind sowohl die Strombegrenzungsschaltung 15 als auch die Spannungsüberwachungsschaltung 20 Transistormeß- bzw. Verstärkerschaltungen:

(1) Die Strombegrenzungsschaltung 15 umfaßt einen Transistor 28, der den Spannungsabfall, welcher an einem im Lastkreis 19 liegenden Stromfühlwiderstand 29 erhalten wird, über einen Basiswiderstand 30 überwacht und über die Steuersignalleitung 14 ein Stromfehlersignal auf die Basis des Leistungstransistors 26 gibt, welches in der oben beschriebenen Weise wirkt.

(2) Die Spannungsüberwachungsschaltung 20 besitzt einen Transistor 31, der den Spannungsabfall am Leistungstransistor 26 überwacht. Der Transistor 31 ist im einzelnen so geschaltet, daß sein Kollektor direkt mit dem Kollektor des Leistungstransistors 26 verbunden ist, während seine Basis über einen Kondensator 34 mit dem lastseitigen Anschluß des Stromfühlwiderstands 29 verbunden und sein Emitter über einen Emitterwiderstand 32 an die Basis des Transistors 25 angekoppelt ist. Zum Entsperren des Transistors 31 ist seine Basis außerdem über einen Widerstand 33 mit der Steuersignalleitung 6 verbunden.

(3) Als Verzögerungsglied 25 ist ein RC-Glied, nämlich der Kondensator 34 zusammen mit dem Widerstand 33, vorgesehen. Dieser Kondensator 34 ist vorzugsweise so bemessen, daß die Ansprechzeit des Leistungsschalters 27 gegenüber Einschaltüberlastungen im Bereich von µsec bis msec liegt. Innerhalb dieser kurzen Zeit wird der Leistungstransistor 26 auch bei Überlastung noch nicht so heiß, daß er zerstört wird, dauert die Überlastung länger, dann wird er jedoch abgeschaltet.

Wie man aus der Figur 2 ersieht, wird das auf der Leitung 23 vorhandene Spannungsfehlersignal dem Transistor 28 zusätzlich zum Stromfehlersignal zugeführt, das durch den Stromfühlwiderstand 29 erhalten wird und mittels des Basiswiderstands 30 an den Transistor 28 angekoppelt ist. Wenn dem Transistor 31 über die Steuersignalleitung 6, die Leitung 24 und den Widerstand 33 kein Steuersignal zugeführt wird, dann geht der Transistor 31 in den sperrenden Zustand über, so daß über den Emitterwiderstand 32 kein Spannungsfehlersignal auf die Basis des Transistors 28 gelangt und infolgedessen die Selbstsperrung des Leistungsschalters 27 nach einem Kurzschluß oder einer Überlastung aufgehoben wird.

Wie durch die Figur 1 bereits angedeutet ist, müssen die Strombegrenzungsschaltung 15 und die Spannungsüberwachungsschaltung 20 keinesfalls unbedingt einfache Transistorschaltungen sein, sondern können auch in anderer geeigneter Weise ausgebildet sein, zum Beispiel kann sowohl die Strombegrenzung als auch die Spannungsüberwachung mittels je eines Operationsverstärkers durchgeführt werden.

Da der Leistungsschalter 1 und 27 eingangsseitig mit einer sehr geringen Steuerleistung auskommt, wie sie von üblichen Steuerschaltungen geliefert wird, nämlich z.B. <100 mW (5 V, 16 mA TTL-pegel), und da er ausgangsseitig so hohe Leistungen schalten kann, wie sie zur direkten Betätigung von Stellgliedern erforderlich sind, nämlich beispielsweise 80 W (40 V, 2 A), ohne daß dieser Leistungsschalter eine nennenswerte Verlustleistung im Überlastungs- und Kurzschlußfall erzeugt, kann er in Vielfachanordnung zusammen mit den entsprechenden Steuerschaltungen zu seiner Steuerung auf einer relativ kleinen Schaltungsplatte untergebracht werden, insbesondere auf einer Einkarte für computerisierte numerische Steuerung von Werkzeugmaschinen, Prozeßsteuereinrichtungen und Industrierobotern, die direkt nicht nur mit den Gebern sondern auch mit den Stellgliedern der Werkzeugmaschine, der Prozeßanlage oder des Industrieroboters verbindbar ist.

Eine solche Einkarte für computerisierte numerische Steuerung von Werkzeugmaschinen oder Industrierobotern, die aufgrund des erfindungsgemäßen Leistungsschalters ermöglicht wird, sei nachstehend anhand der Figur 3 erläutert:

Die Einkarte 35, die eine kostengünstige und außerordentlich leistungsfähige computerisierte numerische Steuerung mit hoher Anwendungsbreite ermöglicht, besitzt als eigentliche Steuereinrichtung einen Prozessor 36. Dieser Prozessor 36 ist eingangs- und ausgangsmäßig über einen internen Bus 37 mit den einzelnen Baueinheiten, die auf der Einkarte 35 untergebracht sind, verbunden, die durch entsprechende Anschlüsse 38 eingangs- und ausgangsseitig an den internen Bus 37 angekoppelt sind (in Figur 3 sind nur einige dieser Anschlüsse aus Gründen einer übersichtlicheren Darstellung mit einem Bezugszeichen versehen).

Auf der Einkarte 35 sind folgende einzelne Baueinheiten vorgesehen: eine Lageregelungsschaltung 39, die ein Istwertsystem 40 und ein Sollwertsystem 41 umfaßt; außerdem gehört zu der Lageregelungsschaltung 39 noch eine Handradeingangsschaltung 42. Die Lageregelungsschaltung 39 dient dazu, entsprechende Achsen 43 in Werkzeugmaschinen, Industrierobotern o.dgl. in ihrer Lage zu regeln, und ist deshalb über Istwerteingänge 44 und über Sollwertausgänge 45 mit den entsprechenden Gebern und Stellgliedern der Achsen 43 verbunden. Zusätzliche Sollwertausgänge vom Sollwertsystem 41 sind bei 46 vorgesehen. Die Handradeingangsschaltung 42 dient dazu, Istwertsysteme nicht genutzter Achsen als Handradeingänge oder als zusätzliche Meßsysteme, zum Beispiel direktes Werkstückmeßsystem, zu nutzen; hierzu sind entsprechende Istwerteingänge 47 vorgesehen, die von zusätzlichen äußeren Gebern herkommen, welche, wie bei 48 angedeutet ist, an einem Handrad, einer Dickenmeßeinrichtung, o.dgl. vorgesehen sind.

Weiterhin ist eine speicherprogrammierbare Steuerschaltung 49 auf der Einkarte 35 vorgesehen, deren Eingangsschaltungen 50 über Eingänge 51 mit Digitalgebern 52, beispielsweise Endschaltern, verbunden werden können, und deren Ausgangsschaltungen 53 über Ausgänge 54 mit Stellgliedern 55 verbunden werden können, wie beispielsweise mit Magnetventilen, Magnetbremsen, Hydraulikventilen, Pumpen o.dgl.

Schließlich sind analoge Eingangsschaltungen 56 vorgesehen, die über entsprechende Eingänge 57 mit Analoggebern 58 der Maschine, des Industrieroboters o.dgl. verbindbar sind; diese Analoggeber 58 können beispielsweise zusätzliche Meßgeräte, Temperaturkontrolleinrichtungen, Grenzwertüberwachungsgeber o.dgl. sein.

Die vorstehend beschriebenen Baueinheiten 39, 49 und 56 bilden gewissermaßen den maschinen- bzw. industrieroboterseitigen Teil der Einkarte 35, die außerdem noch einen datenverarbeitungsseitigen Teil aufweist, der nachstehend kurz erläutert ist und folgendes umfaßt:

Zunächst ist ein Systemspeicher 59 vorgesehen, der dazu dient, das Grundprogramm zu speichern, welches von der jeweiligen speziellen Anwendung der Einkarte 35 abhängt. Dieser Systemspeicher kann durch entsprechende Steckplätze, die auf der Einkarte 35 vorgesehen sind, erweitert werden, wie bei 60 angedeutet ist.

Weiter befindet sich auf der Einkarte 35 ein Anwenderspeicher 61, in den die speziellen Daten, mit denen das im Systemspeicher 59 gespeicherte Grundprogramm betrieben werden soll, eingegeben werden. Der Anwenderspeicher 61 ist, wie bei 62 angedeutet, wahlweise mit EPROM-Speichern anstelle von CMOS-Speichern durch entsprechende, auf der Einkarte 35 vorgesehene Steckplätze bestückbar. Es sei darauf hingewiesen, daß alle Speicherbereiche des Anwenderspeichers 61 gepuffert sind.

Weiter ist eine serielle Dateneingabe-/-ausgabeeinheit 63 vorgesehen, die über Anschlüsse 64 an äußere Datenspeicher- bzw. -verarbeitungsgeräte 65 angeschlossen werden kann, zum Beispiel zum Zwecke der programmeingabe in den Anwenderspeicher 61, oder zum Anschluß eines externen Rechners zur direkten Steuerung oder zum Zwecke der Kommunikation zwischen mehreren Maschinen (Datenaustausch).

Eine parallele Dateneingabe-/-ausgabeeinheit 66 auf der Einkarte 35 kann über Anschlüsse 67 an entsprechende Datenspeicher- bzw. -verarbeitungsgeräte 68 angeschlossen werden, zum Beispiel an einen Drucker, einen Lochstreifenstanzer oder -leser o.dgl.

Zum datenverarbeitungsseitigen Teil gehören außerdem noch eine Video-Schnittstelle 69 und eine Tastatur-Schnittstelle 70, von denen erstere über Ausgangsanschlüsse 71 an einen Videomonitor 72 und letztere über Eingangsanschlüsse 73 an eine Tastatur 74 einer Bedientafel 75 anschließbar ist.

Schließlich besitzt die Einkarte 35 noch eine Rechnerkopplungseinheit 76 mit Speicher 77 und eine Buserweiterungseinheit 78. Mittels der Rechnerkopplung 76 können, wie bei 80 angedeutet ist, zwei identische Einkarten 35 direkt miteinander gekoppelt werden. Die Buserweiterung 78 ist eine Schnittstellenerweiterung für Hardware.

Es seien nachstehend Daten einer bevorzugten Ausführungsform einer Einkarte 35 angegeben:

(a) Lageregelungsschaltung 39

Achsenzahl: 6 lageregelte Achsen

Istwertsystem: Inkrementale Impulsgeber mit einem Nullimpuls. Die Istwertimpulse werden in einem zyklisch absoluten Istwertzähler (16 Bit) aufsummiert und von der Lageregelung im Lageregeltaktübernommen.

Sollwertsystem: 8 Sollwertausgänge mit 12 Bit D/A-Wandler ± 10 V und Reglerfreigabesignal (6 lagegeregelte Achsen + 2 Ausgänge für z. B. Drehzahlsollwert oder Sollwert für Schweißstrom o.ä.).

Abtastrate ist auf 2, 4, 8, 16 msec einstellbar.

(b) Eingangsschaltungen 50

umfassen 64 optoentkoppelte digitale 24V-Eingänge. Bei integrierter SPS können alle Eingänge (außer Referenzpunkt, Reglerfreigabe und Endschalter) frei belegt werden. Zusätzlich lassen sich NC-interne Zustände unmittelbar abfragen.

(c) Ausgangsschaltungen 52

umfassen 48 optoentkoppelte dauerkurzschlußfeste überlastgeschützte digitale 24V-Ausgänge. Bei integrierter SPS sind alle 48 Ausgänge frei belegbar. Alle Ausgänge sind für 2 A ohmsche oder induktive Lasten ausgelegt. Lampenlast max. 6 W. Ausgänge sind überlastsicher und kurzschlußfest; mittels Leistungsschaltern 1 bzw. 27 aufgebaut.

(d) Analoge Eingangsschaltungen:

Für +/- 10 V jeweils 4 Eingänge mit 8 Bit A/D-Wandler und für 0 bis 5 V jeweils 12 Eingänge mit 8 Bit A/D-Wandler.

(e) Prozessor 36:

Vorgesehen ist ein 16 Bit Mikroprozessor MC 68000 mit 4, 8, (10), (12) MHz und 24 Bit Adreßraum.

(f) Systemspeicher 59:

Vorhanden sind 10 Steckplätze für unterschiedliche EPROM-Typen (Systemprogrammspeicher), nämlich

2716 10 x 2 KB = 20 KB
2732 10 x 4 KB = 40 KB
2764 10 x 8 KB = 80 KB
27128 10 x 16 KB = 160 KB
27256 10 x 32 KB = 320 KB

(g) Anwenderspeicher 61:

Vorhanden sind 8 Steckplätze à 2, 4, 8 KB CMOS, wahlweise auch mit 2716, 2732, 2764 EPROM bestückbar,

Arbeitsspeicher 4 KB
integrierte SPS (4 KB)
NC-Programmspeicher 4 - 60 KB

(h) Serielle Dateneingabe/-ausgabeeinheit 63:

Vorgesehen sind drei V24-Schnittstellen mit prgrammierbarer Baudrate (50-19200), davon eine auf 20 mA umschaltbar.

(i) Parallele Dateneingabe/-ausgabeeinheit 66:

Vorgesehen sind 8 programmierbare Ein-/Ausgänge plus 4 Steuersignale (TTL), z. B. für Lochstreifen-Stanzer/ Leser oder weiteres Tastatur-Interface.

(j) Video-Schnittstelle 69:

Grafik 512 x 512 Punkte Auflösung, Vektorgenerator ASCII Zeichensatz, Schriftgröße variabel von 5 x 8 bis 80 x 128 Punkte einstellbar, inverse Darstellung der Schrift, Cursorgröße und -blinkzeit programmierbar.

(k) Tastaturschnittstelle 70:

Umfassend 72 Tasten, und zwar 12 Tasten zur Zahleneingabe und 60 Funktionstasten.

(l) Buserweiterungseinheit 78:

Gepufferte Buserweiterung mit einem Adreßraum von 128 KW für anwendungsabhängige Schnittstellen oder Speichererweiterung

(m) Rechnerkopplungseinheit 76:

Die Kopplung zweier Karten zu maximal 12 Achsen oder 4 Handrädern und 8 Achsen ist möglich.

(n) Spannungsversorgung:
5 V und +/- 15 V

## Patentansprüche

1. Leistungsschalter (1, 27), insbesondere Leistungstransistorschalter, mit einer den durch das Leistungsschalterelement (2, 26) fließenden Strom überwachenden und ein Überschreiten eines vorbestimmten Grenzstromwerts durch Steuerung des Leistungsschalterelements (2, 26) verhindernden Strombegrenzungsschaltung (15), und mit einer den Spannungsabfall am Leistungsschalterelement (2, 26), insbesondere an einem Leistungstransistor (26), überwachenden Spannungsüberwachungsschaltung (20), die in einer Mitkopplungsschaltung mit der Strombegrenzungsschaltung (15) verbunden ist, dadurch gekennzeichnet, daß die Spannungsüberwachungsschaltung (20) an das das Leistungsschalterelement (2, 26) schaltende Steuersignal angekoppelt, ohne dieses Steuersignal unwirksam und eine durch das Steuersignal entsperrbare Transistorschaltung ist.

2. Leistungsschalter nach Anspruch 1, dadurch gekennzeichnet, daß die Spannungsüberwachungsschaltung (20) mit einem deren Wirksamwerden nach dem Einschalten verzögernden Verzögerungsglied (25, 32, 34) versehen ist.

3. Leistungsschalter nach Anspruch 2, dadurch gekennzeichnet, daß die Verzögerung der Spannungsüberwachungsschaltung (20) während des Einschaltens derselben im Millisekunden-Bereich liegt.

4. Leistungsschalter nach Anspruch 1, 2 oder 3, dadurch gekennzeichnet, daß die Steuersignalleitung (6), welche das Steuersignal zum Öffnen und Schließen des Leistungsschalterelements (2, 26) zuführt, mit der dasselbe abgebenden Steuereinrichtung durch einen Optokoppler (7) verbunden ist.

5. Leistungsschalter nach Anspruch 2 oder 3, dadurch gekennzeichnet, daß das Verzögerungsglied (25) ein Widerstands-Kondensator-Glied (33, 34) ist.

6. Leistungsschalter nach einem der Ansprüche 1 bis 4, dadurch gekennzeichnet, daß eine über einen Optokoppler (103) verlaufende Rückführung (107) für ein Signal, welches anzeigt, ob das Leistungsschalterelement (2, 26) durchgeschaltet hat, vorgesehen ist.

7. Leistungsschalter nach einem der Ansprüche 1 bis 6, dadurch gekennzeichnet, daß er als Leistungsausgangsstufe zusammen mit der sein Steuersignal erzeugenden Steuerschaltung in einer gemeinsamen Steuerbaueinheit, insbesondere auf einer Steuerkarte (35) für computerisierte numerische Steuerung vorgesehen ist.

8. Leistungsschalter nach Anspruch 7, dadurch gekennzeichnet, daß er in Vielfachanordnung in einem Steuerbaustein, insbesondere auf einer Steuerkarte (35), für computerisierte Steuerung zum Schalten von digitalen Ausgängen vorgesehen ist, in dem bzw. auf der zum Erzeugen der Steuersignale wenigstens ein Prozessor (36) mit Speicher (59, 61) und analoge und digitale Eingänge (50, 53, 56) sowie gegebenenfalls digitale und/oder analoge Ist- und/oder Sollwertschaltungen (40, 41, 42) und gegebenenfalls eine oder mehrere Schnittstellen (63, 66, 69, 70) zum Anschluß an Datenverarbeitungseinrichtungen (65, 68) und Bedienungseinrichtungen (72, 74, 75) vorgesehen sind.

9. Leistungsschalter nach Anspruch 7 oder 8, dadurch gekennzeichnet, daß er in Vielfachanordnung auf einer Einkarte (35) für mehrachsige computerisierte numerische Steuerung von Werkzeugmaschinen oder Industrierobotern vorgesehen ist.

10. Leistungsschalter nach einem der Ansprüche 1 bis 9, dadurch gekennzeichnet, daß eine den Kurzschluß- oder Überlastfall erfassende Rückführung (107) vorgesehen ist, die so ausgebildet ist, daß der gesamte Leistungsschalter (1, 27) auch als digitaler Nur-Eingang nutzbar ist.

## Claims

1. A power switch (1, 27), in particular a power transistor switch, with a current limiting switch (15) which monitors the current flowing through the power switch element (2, 26) and prevents a predetermined limit current value from being exceeded by the controlling of the power switch element (2, 26), and with a voltage monitoring switch (20) which monitors the fall in voltage on the power switch element (2, 26), in particular on a power transistor (26), which voltage monitoring switch is connected in a postive feedback switch with the current limiting switch (15), characterised in that the voltage monitoring switch (20) is coupled to the control signal which switches the power switch element (2, 26), is ineffective without this control signal and is a transistor switch which can be unblocked by the control signal.

2. A power switch according to claim 1, characterised in that the voltage monitoring switch (20) is provided with a time-element (25, 32, 34) which delays its operation after it has been connected.

3. A power switch according to claim 2, characterised in that the delaying of the voltage monitoring switch (20) during the connection of the same is in the millisecond range.

4. A power switch according to claim 1, 2 or 3, characterised in that the control signal lead (6) which supplies the control signal for the opening and closing of the power switch element (2, 26) is connected with the control device releasing the same by means of an optocoupler (7).

5. A power switch according to claim 2 or 3, characterised in that the time-element (25) is a resistance capacitor part (33, 34).

6. A power switch according to one of claims 1 to 4, characterised in that a feedback (107) running via an opto-coupler (103) is provided for a signal which indicates whether the power switch element (2, 26) has switched through.

7. A power switch according to one of claims 1 to 6, characterised in that it is provided for computerised numerical control as a power output stage together with the control switch producing its control signal in a common control constructional unit, in particular on a control card (35).

8. A power switch according to claim 7, characterised in that it is provided for computerised control for the switching of digital outputs in multiple arrangement in a control module, in particular on a control card (35), in which module and/or on which control card the following are provided for for the production of the control signals: at least one microprocessor (36) with a memory (59, 61) and continuously modulated and digital inputs (50, 53, 56) and optionally digital and/or continuously modulated analogue value switches and/or set value switches (40, 41, 42) and optionally one or more interfaces (63, 66, 69, 70) for connection with data processing installations (65, 68) and command devices (72, 74, 75).

9. A power switch according to claim 7 or 8, characterised in that it is provided in multiple arrangement on an insertion card (35) for the multi-axis computerised numerical controlling of machine tools or industrial robots.

10. A power switch according to one of claims 1 to 9 characterised in that a feedback (107) which detects the instance of a short circuit or overload is provided which is designed in such a way that the entire power switch (1, 27) can also be used as a digital input only.

## Revendications

1. Commutateur de puissance (1,27), en particulier commutateur de puissance à transistor, comportant un montage limiteur de courant (15) contrôlant le courant passant par l'élément de commutation de puissance (2, 26) et empêchant le dépassement d'une intensité-limite prédéterminée par commande de l'élément de commutation de puissance (2, 26), et comportant un montage de contrôle de tension (20) contrôlant la chute de tension sur l'élément de commutation de puissance (2, 26), en particulier sur un transistor de puissance (26), relié au montage limiteur de courant (15) en formant une boucle à rétroaction, caractérisé en ce que le montage de contrôle de la tension (20) reçoit le signal de commande commandant l'ouverture et la fermeture de l'élément de commutation de puissance (2, 26), est inactif sans ce signal de commande et est un montage à transistor pouvant être bloqué par le signal de commande.

2. Commutateur de puissance selon la revendication 1, caractérisé en ce que le montage de contrôle de tension (20) comporte un élément à retard (25, 32, 34) retardant l'activation après sa mise en circuit.

3. Commutateur de puissance selon la revendication 2, caractérisé en ce que le retard du montage de contrôle de tension (20) est de l'ordre des millisecondes pendant sa mise en circuit.

4. Commutateur de puissance selon la revendication 1, 2 ou 3, caractérisé en ce que le conducteur de transmission de signaux de commande (6) qui amène le signal de commande d'ouverture et de fermeture de l'élément de commutation de puissance (2, 26) est relié au dispositif de commande qui le délivre par un optocoupleur (7).

5. Commutateur de puissance selon la revendication 2, ou 3, caractérisé en ce que l'élément à regard (25) est un élément à résistance et condensateur (33, 34).

6. Commutateur de puissance selon l'une des revendications 1 à 4, caractérisé en ce qu'il est prévu un trajet de réinjection (107) passant par un optocoupleur (103) pour un signal qui indique si l'élément de commutation de puissance (2, 26) a été mis en circuit.

7. Commutateur de puissance selon l'une des revendications 1 à 6, caractérisé en ce qu'il est prévu, en tant qu'un étage de sortie de puissance, sous la forme d'un module de commande commun avec le montage de commande produisant son signal de commande, en particulier sur une carte de commande (35) pour commande numérique informatisée.

8. Commutateur de puissance selon la revendication 7, caractérisé en ce qu'il est prévu en montage multiple dans un module de commande, en particulier sur une carte de commande (35) pour commande informatisée de commutation de sorties numériques, dans lequel ou sur laquelle, pour engendrer les signaux de commande, il est prévu au moins un processeur (36) avec une mémoire (59, 61) et des entrées analogiques et numériques (50, 53, 56), ainsi éventuellement que des montages de valeurs réelles et/ou prescrites (40, 41, 42) numériques et/ou analogiques et éventuellement un ou plusieurs interfaces (63, 66, 69, 70) pour le raccordement aux installations de traitement des données (65, 68) et aux dispositifs de manoeuvre (72, 74, 75).

9. Commutateur de puissance selon la revendication 7 ou 8, caractérisé en ce qu'il est prévu en montage multiple sur une carte de commande (35) pour commande numérique informatisée multiple de machines-outils ou de robots industriels.

10. Commutateur de puissance selon l'une des revendications 1 à 9, caractérisé en ce qu'il est prévu un trajet de réinjection (107) détectant les courts-circuits et les surcharges, conformé de façon que l'ensemble du commutateur de puissance (1, 27) puisse aussi être utilisé comme entrée numérique seulement.

FIG.1

FIG.2

FIG. 3

Prozessor MC 68000 8 (12) MHz — 36

— 35 — 37

**2 digitale Istwertkreise (Handrad)** — 42 — 48, 47

**4 digitale Istwertkreise** — 40, 38, 39
**Lageregelkreis** — 44
**8 analoge Sollwertkreise** — 45, 41

X, V, Z — 43, 43, 46

**64 digitale 24 V-Eingänge** — 51, 50 — 52
**Integrierte SPS** — 49
**48 digitale 24 V-Ausgänge (0,5 A)** — 54, 53 — 55

**16 analoge Eing. 8 Bit Auflösung (Sensoren)** — 57, 56 — 58, M₀

**Buserweiterung** — 78

**Systemspeicher 80 KB EPROM 4 KB CMOS** — 59
**Erweiterung auf 27128 und 27256** — 60

**Anwenderspeicher 4-28 KB CMOS** — 61
**Wahlweise mit EPROM bestückbar** — 62

38

**3 serielle E/A V 24 und 20 mA** — 63, 64
**DNC Terminal Kassette** — 65

**10 Bit parallel TTL E/A** — 66, 67 — 68

**Video-Interface 512 × 512 Pkt.** — 69, 71

**Tastatur Interface 64 Tasten** — 70, 73

**Bedientafel** — 72, 75, 74

**Rechnerkopplung 2. Karte SPEICHER** — 76, 77, 80

+ 5V
+15V
−15V